(19) Europäisches Patentamt
European Patent Office
Office européen des brevets

(11) **EP 0 782 002 B1**

(12) **EUROPÄISCHE PATENTSCHRIFT**

(45) Veröffentlichungstag und Bekanntmachung des Hinweises auf die Patenterteilung:
**10.12.2003 Patentblatt 2003/50**

(51) Int Cl.$^7$: **G01R 15/20**, G01R 19/32

(21) Anmeldenummer: **95120621.8**

(22) Anmeldetag: **27.12.1995**

(54) **Verfahren und Vorrichtung zum potentialfreien Erfassen eines Stromes**

Method of and means for contact free measurement of a current

Procédé et dispositif pour mesurer un courant sans contact galvanique

(84) Benannte Vertragsstaaten:
**DE ES FR GB IT**

(43) Veröffentlichungstag der Anmeldung:
**02.07.1997 Patentblatt 1997/27**

(73) Patentinhaber: **Hamilton Sundstrand Corporation Rockford, Illinois 61125-7003 (US)**

(72) Erfinder: **Möhnle, Jürgen**
**D-86720 Nördlingen (DE)**

(74) Vertreter: **Leckey, David Herbert**
**Frank B. Dehn & Co.,**
**European Patent Attorneys,**
**179 Queen Victoria Street**
**London EC4V 4EL (GB)**

(56) Entgegenhaltungen:
**EP-A- 0 382 217        EP-A- 0 539 081**
**CH-A- 676 646        DE-A- 4 318 716**

• **IEEE INSTRUMENTATION AND MEASUREMENT TECHNOLOGY CONFERENCS, 18. - 20.Mai 1993, IRVINE,CA,US, Seiten 737-740, XP002003056 MATSUNO ET AL.: "a temperature-compensated bridge circuit"**

EP 0 782 002 B1

**Beschreibung**

Die Erfindung betrifft ein Verfahren und eine Vorrichtung zum potentialfreien Erfassen eines Stromes, insbesondere eines Ausgangsstromes in einem stromüberwachten Leistungsschalter, bei dem ein Magnetfeldsensor vier zu einer mit einer Speisespannung gespeisten Brückenschaltung zusammengeschaltete Bauelemente enthält, wovon mindestens zwei Bauelemente magnetfeldempfindlich sind, die einem durch den Strom hervorgerufenen Primärmagnetfeld ausgesetzt werden. Der in DE-A-4318716 dargestellte Magnetfeldsensor enthält eine solche Brückenschaltung.

Bekannt sind Verfahren und Vorrichtungen zum potentialfreien und somit berührungslosen und rückwirkungsfreien Erfassen des Stromes, bei denen die Brückenspannung der Brückenschaltung einer Regeleinheit zugeführt wird, welche einen Kompensationsstrom erzeugt, dessen Kompensationsmagnetfeld derart auf die magnetfeldempfindlichen Bauelemente einwirkt, daß die Brückenspannung einen betragsmäßig minimalen Wert, vorzugsweise Null, annimmt. Durch diese Maßnahme arbeitet der Magnetfeldsensor in einem vorgegebenen Arbeitspunkt, so daß keine Meßfehler durch ein nicht lineares Verhalten der magnetfeldempfindlichen Bauelemente an anderen Arbeitspunkten entstehen. Der in EP-A-0539081 dargestellte Stromsensor verwendet einen Kompensationsstrom um die Widerstandsveränderung eines Magneto-Widerstandselements auszugleichen. Diese Vorrichtung weist aber keine Brückenschaltung auf.

Aus dem Kompensationsstrom wird bei bekannten Verfahren ein Meßsignal ermittelt, welches als Maß für den zu erfassenden Strom dient. Bekannt sind verschiedene Schaltungsanordnungen, die Meßfehler durch den Einfluß unterschiedlicher Temperaturen am Magnetfeldsensor vermeiden sollen. So kann z.B. die Temperatur am Magnetfeldsensor mit einem Temperatursensor erfaßt werden und abhängig von der Temperatur das Meßsignal korrigiert werden.

Bei bestimmten Anwendungen, bei denen eine hohe Meßgenauigkeit des Stromes über einen großen Temperaturbereich von z.B. 100 K gewährleistet sein muß, treten trotz Verwenden der Brückenschaltung und zusätzlicher Korrektur des Meßsignals abhängig von der Temperatur, z.B. mit Hilfe eines Temperatursensors, zu große Meßfehler bei Temperaturschwankungen auf.

Aufgabe der Erfindung ist es, ein potentialfreies Erfassen eines Stromes mit kleinen Meßfehlern über einen großen Temperaturbereich zu ermöglichen.

Diese Aufgabe wird, durch die Merkmale der Ansprüche 1 und 17 gelöst. Die magnetfeldempfindlichen Bauelemente, z.B. magnetoresistive Widerstände, reagieren auf Temperaturänderungen mit einem veränderten elektrischen Verhalten, was sich in einer Änderung der Ansprechbarkeit oder Empfindlichkeit und in einer Änderung des Temperaturkoeffizienten bemerkbar macht. Während die Änderung der Magnetfeld-Empfindlichkeit unkritisch ist, da sich lediglich die Regelabweichung im Regelkreis geringfügig ändert, hat die Änderung des Temperaturkoeffizienten erhebliche Auswirkungen. Diese Änderung ist im allgemeinen von magnetoresistivem Widerstand zu Widerstand aufgrund herstellungstechnischer Parameter unterschiedlich. So kann ein Widerstand einen hohen positiven Temperaturkoeffizienten haben, während ein anderer Widerstand einen geringen positiven Temperaturkoeffizienten hat. Durch Temperaturänderung wird demzufolge die Brücke verstimmt, ohne daß das Primärmagnetfeld sich geändert hat. Der Regelkreis versucht nun diese Verstimmung der Brücke durch Änderung des Kompensationsstromes auszugleichen. Je nach Art der Temperaturkoeffizienten der magnetoresistiven Widerstände wird die Brücke durch eine Änderung des Kompensationsstroms wieder vollständig abgeglichen. Bei anderen Temperaturkoeffizienten kann ein vollständiger Ausgleich der Verstimmung jedoch nicht möglich sein, da der Betrag der Feldstärke des Kompensationsmagnetfeldes auf jeden magnetfeldempfindlichen Widerstand gleichermaßen einwirkt.

Unabhängig von den jeweiligen Temperaturkoeffizienten ist der geschlossene Regelkreis bemüht, die Brückenspannung durch Änderung des Kompensationsstromes betragsmäßig zu minimieren. Demzufolge wird sich, bis auf ganz wenige Ausnahmen bei idealen magnetoresistiven Widerständen, bei Temperaturänderung ohne Änderung des Stromes ein Kompensationsstrom einstellen, der einen geänderten Strom vortäuscht. Durch die unterschiedlichen Temperaturkoeffizienten ändert sich bei Fließen des Kompensationsstromes auch die erfaßte Spannung über dem Bauelement entweder durch eine Veränderung der Spannung bei vollständig abgeglichener Brücke oder durch eine verbleibende Brückenspannung, die durch den Regelkreis aus den genannten Gründen nicht ausgeregelt werden kann. Das Resultat ist, daß das Meßsignal mit einem Meßfehler behaftet ist und sich gleichzeitig die erfaßte Spannung an dem Bauelement ändert.

Bei der Erfindung wird die an mindestens einem der Bauelemente erfaßte Spannung mit einer Bezugsspannung verglichen, die bei einer Bezugstemperatur an diesem Bauelement anliegt, um die Abweichung beider Spannungen als Maß für den Einfluß der Temperatur zu erfassen. Das Ergebnis des Vergleichs wird zur Korrektur des aus dem Kompensationsstrom ermittelten und mit einem Temperaturfehler behafteten Meßsignals verwendet. Vergleichsergebnis und Temperaturfehler des Kompensationsstromes stehen in einem z.B. durch empirische Messungen quantifizierbaren Verhältnis.

Vorzugsweise sind die beiden magnetfeldempfindlichen Bauelemente als magnetoresistive Widerstände und die verbleibenden Bauelemente als Festwiderstände ausgebildet. Die magnetoresistiven Widerstände können in Dünnschichttechnik hergestellt sein, so daß sich ein Magnetfeldsensor kleiner Bauform und hoher Empfindlichkeit ergibt.

Wird in jedem der magnetoresistiven Widerstände die Magnetachse der bevorzugten Magnetisierung um etwa 45° gegen die Richtung des Stromflusses geneigt, so ergibt sich eine Erhöhung der Empfindlichkeit der Kennlinie des magnetischen Widerstandes dieser Bauelemente über die Magnetfeldstärke für schwache äußere Magnetfelder. Vorzugsweise läßt sich der Winkel zwischen der Magnetachse und der Stromflußrichtung durch den jeweiligen magnetoresistiven Widerstand mit geringem Aufwand dadurch realisieren, daß auf die magnetoresistiven Widerstände hochleitfähige Äquipotentialflächen aufgebracht werden, die unter dem Begriff Barberpole bekannt sind. Als Magnetachse der bevorzugten Magnetisierung wird dabei eine bei der Herstellung vorgegebene Vorzugsachse der spontanen Magnetisierung bezeichnet.

Eine hohe Empfindlichkeit des Magnetfeldsensors läßt sich dadurch erreichen, daß die Führung des Stromes und des durch ihn erzeugten Primärfeldes derart ist, daß in einander benachbarten magnetoresistiven Widerständen abwechselnd positive und negative Widerstandsänderungen um annähernd den gleichen Betrag bei Änderung des auf sie einwirkenden Magnetfeldes auftreten. Die Brückenspannung ändert sich durch diese Maßnahme maximal, wodurch die Empfindlichkeit des Magnetfeldsensors erhöht wird. Alternativ kann durch eine unterschiedliche Ausrichtung der Magnetachsen der magnetoresistiven Widerstände die gleiche Wirkung erreicht werden.

In einer besonders bevorzugten Ausführungsform sind sämtliche Bauelemente der Brückenschaltung als magnetoresistive Widerstände ausgebildet. Die Empfindlichkeit des Magnetfeldsensors wird dadurch erhöht, da die Brückenschaltung durch das mit dem zu erfassenden Strom verbundene Primärmagnetfeld stärker verstimmt werden kann.

Die Änderungen der Spannung am Bauelement abhängig von der Temperatur bei vorhandenem Kompensationsstrom und abgeglichener Brückenschaltung sind bei geeigneter Wahl der magnetfeldempfindlichen Bauelemente annähernd linear. Eine einfache Korrektur des Meßsignals bezüglich eines Temperaturfehlers läßt sich in diesem Fall dadurch erreichen, daß der Vergleich der Spannung am Bauelement mit der Bezugsspannung an demselben Bauelement durchgeführt wird, indem die Differenz der beiden Spannungen gebildet wird. Durch Multiplizieren der Differenz mit einem in einem Einmeßvorgang ermittelten Einmeßfaktor und anschließender Addition zum Meßsignal kann die Korrektur des Meßsignals mit geringem schaltungstechnischem Aufwand durchgeführt werden. Das Vorzeichen des Einmeßfaktors hängt dabei vom jeweiligen verwendeten Magnetfeldsensor ab. Das Bilden der Differenz, das Multiplizieren des Einmeßfaktors K und die anschließende Addition können sowohl analog als auch in einer digitalen Steuerung erfolgen.

Beim Einmeßvorgang werden mindestens zwei Messungen der Spannung am Bauelement und des zugehörigen Kompensationsstromes bei betragsmäßig minimaler Brückenspannung und bei unterschiedlichen Temperaturwerten durchgeführt. Da das Temperaturverhalten der Spannung annähernd linear ist, können die beiden Meßwerte für die Spannung durch eine Gerade verbunden werden. Das gleiche gilt für die beiden Meßwerte des Kompensationsstromes. Durch Vergleich des Anstiegs der beiden Geraden kann der Einmeßfaktor K so bestimmt werden, daß bei einer Multiplikation der Spannung mit dem Einmeßfaktor K eine Kompensationsgröße entsteht, die den Einfluß der Temperatur auf den Kompensationsstrom Ik bzw. auf das Meßsignal M aufhebt.

Wird der Kompensationsstrom in einem kleineren Abstand als der zu erfassende Strom an den magnetfeldempfindlichen Bauelementen vorbeigeführt, so kann der Kompensationsstrom um Größenordnungen kleiner als der zu erfassende Strom sein, da das Primärmagnetfeld mit zunehmender Entfernung vom zu erfassenden Strom kleiner wird. Mit Hilfe eines relativ kleinen Kompensationsstroms, der ein Kompensationsmagnetfeld mit kleiner Feldstärke erzeugt, kann die Feldstärke des Primärmagnetfeldes am entsprechenden magnetfeldempfindlichen Bauelement aufgehoben werden.

Die Erfindung betrifft weiterhin eine Vorrichtung zum Durchführen des Verfahrens. Durch den Einsatz einer elektronischen Schaltungsanordnung kann das Verfahren zum potentialfreien Erfassen eines Stromes unter Verwenden der analogen Schaltungstechnik mit geringem Fertigungsaufwand durchgeführt werden. Zweckmäßig ist der Einsatz der Hybridtechnik, da sich u.a. eine kompakte Bauweise und ein gutes Temperaturverhalten der gesamten Schaltung aufgrund der hohen Wärmeleitfähigkeit des verwendeten Keramiksubstrates ergeben.

Mit dem Verfahren nach der Erfindung ergibt sich über einen Temperaturbereich von 150 K bei ± 1 V Meßsignal eine Abweichung von < ± 20 mV gegenüber bekannten Verfahren mit einer Abweichung von ± 100 mV.

Die Erfindung wird im folgenden anhand der Figuren näher erläutert. Darin zeigen:

Figur 1     eine Prinzipzeichnung eines als Stromsensor ausgebildeten Ausführungsbeispiels,

Figur 2     ein Blockschaltbild eines stromüberwachten Leistungsschalters unter Verwendung des Stromsensors,

Figur 3     einen schematischen Aufbau eines Leistungsteils des stromüberwachten Leistungsschalters in Hybridtechnik,

Figur 4     eine Schnittdarstellung des Leistungsteils entlang des Schnittes IV-IV nach Figur 3,

Figur 5 die Wirkungsweise eines Magnetfeldsensors,

Figur 6 eine Schaltungsanordnung des Stromsensors für unipolare Ströme,

Figur 7 eine Schaltungsanordnung des Stromsensors für bipolare Ströme, und

Figur 8 zwei Diagramme zum Erläutern eines Einmeßvorganges.

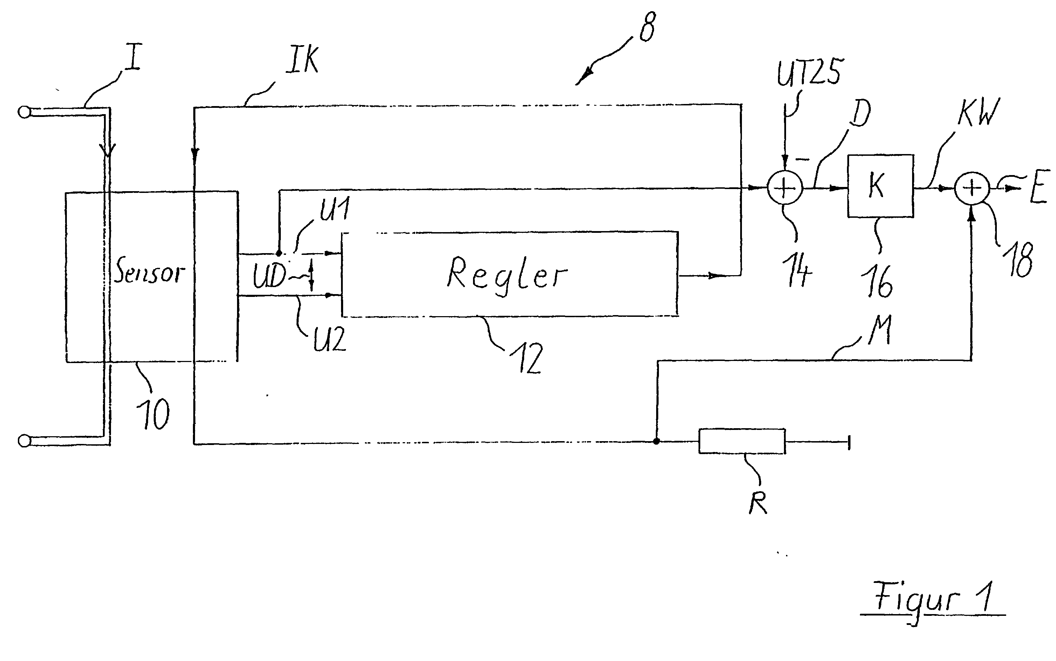

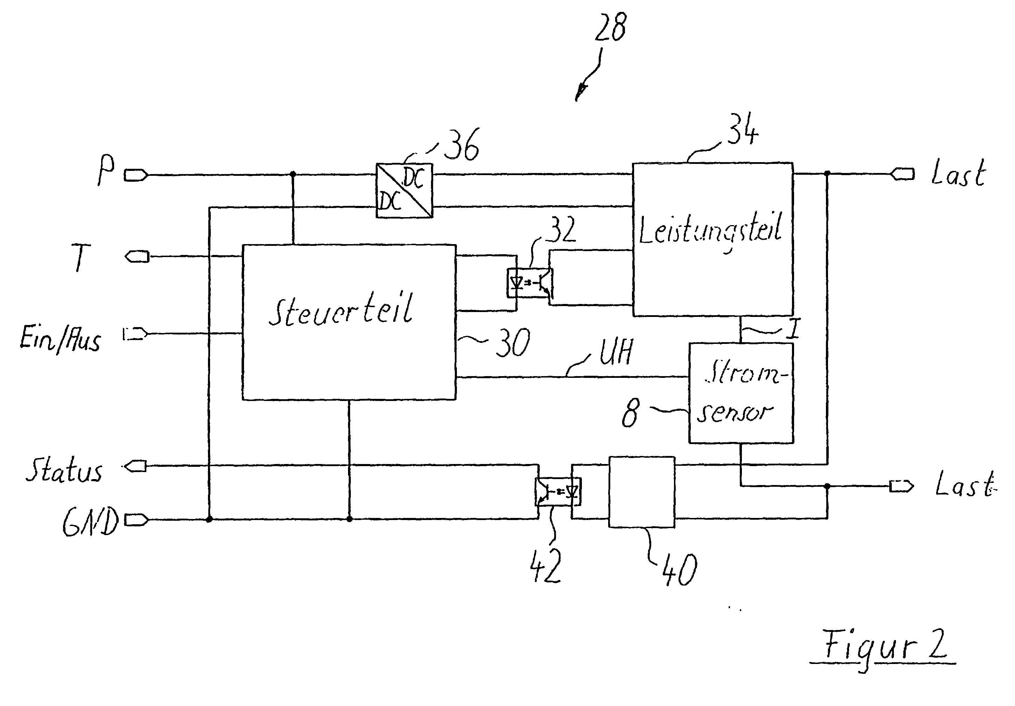

Figur 1 zeigt eine Prinzipzeichnung eines als Stromsensor 8 ausgebildeten Ausführungsbeispiels nach der Erfindung. Zum potentialfreien Erfassen eines Stromes I in einem stromüberwachten Leistungsschalter 28 (vgl. Figur 2) wird dieser an einem Magnetfeldsensor 10 vorbeigeführt. Der Magnetfeldsensor 10 enthält vier zu einer Brückenschaltung zusammengeschaltete magnetfeldempfindliche Widerstände, auf die ein durch den Strom I hervorgerufenes Primärmagnetfeld einwirkt, so daß die Brückenschaltung bei fehlendem Kompensationsmagnetfeld verstimmt wird. An zwei Ausgängen des Magnetfeldsensors 10 wird eine Brückenspannung UD abgegriffen, die die Differenz aus an Widerständen der Brückenschaltung anliegenden Spannungen U1 und U2 an den Ausgängen des Magnetfeldsensors 10 ist.

Die Brückenspannung UD liegt an den Eingängen eines Reglers 12 an, der einen Kompensationsstrom Ik erzeugt. Der Kompensationsstrom Ik wird an den magnetfeldempfindlichen Widerständen des Magnetfeldsensors 10 in der Weise vorbeigeführt, daß ein durch ihn hervorgerufenes Kompensationsmagnetfeld dem Primärmagnetfeld an den magnetfeldempfindlichen Widerständen entgegenwirkt. Der Kompensationsstrom Ik ist durch den Regler 12 so bemessen, daß die Brückenspannung UD einen betragsmäßig minimalen Wert annimmt, vorzugsweise Null, so daß die Brückenschaltung abgeglichen ist. Damit ist der Kompensationsstrom Ik ein Maß für den Strom I. Durchfließt der Kompensationsstrom Ik einen Präzisionswiderstand R, so kann aufgrund des Spannungsabfalls ein Meßsignal M abgegriffen werden.

Da sich der Widerstand der magnetfeldempfindlichen Widerstände bei Temperaturänderungen aufgrund von Fertigungstoleranzen und Einflüssen der Anordnung im Magnetfeldsensor 10 unterschiedlich ändert, kommt es zu Meßfehlern. Je nach Größe der Temperaturkoeffizienten der magnetoresistiven Widerstände wird die Brückenschaltung durch eine zugehörige Änderung des Kompensationsstromes wieder vollständig abgeglichen. Bei anderen Größen der Temperaturkoeffizienten kann ein vollständiger Abgleich der Brücke verhindert sein, da der sich ändernde Kompensationsstrom auf jeden magnetfeldempfindlichen Widerstand gleichermaßen einwirkt. In jedem Falle kommt es durch die unterschiedlichen Temperaturkoeffizienten der magnetoresistiven Widerstände neben einer Änderung des Kompensationsstromes Ik zu einem veränderten Wert der Spannung Ul. Der veränderte Kompensationsstrom Ik täuscht ein verändertes Primärmagnetfeld vor und führt demzufolge in einem aus dem Strom Ik abgeleiteten Meßsignal zu einem Meßfehler, der jedoch durch Auswerten der Spannung U1 beseitigt wird.

Die Spannung U1 wird mit einer Bezugsspannung UT25 verglichen, die der Spannung U1 bei einer Bezugstemperatur T25 von 25°C am Magnetfeldsensor 10 entspricht. Der Vergleich erfolgt durch Bilden einer Differenz D an einem Subtrahierglied 14. Die am Ausgang des Subtrahiergliedes 14 entstehende Differenz D gibt den Einfluß der Temperatur am Magnetfeldsensor 10 auf die Brückenspannung UD an. Der Zusammenhang zwischen der Differenz D und der Temperatur ist beim Verwenden von magnetoresistiven Widerständen annähernd linear. Durch Multiplizieren der Differenz D mit einem Einmeßfaktor K in einem Multiplizierglied 16 entsteht ein Korrekturwert KW. Der Einmeßfaktor K kann sowohl positiv als auch negativ sein. Sein Wert wird in einem weiter unten beschriebenen Einmeßvorgang bestimmt.

Der Korrekturwert KW wird zum Meßsignal M in einem Addierglied 18 addiert, womit der Einfluß der Temperaturänderung auf das Meßsignal M beseitigt wird. Am Ausgang des Addiergliedes 18 entsteht das Ergebnis E, das ein korrigiertes Maß für den Strom I ist. Abhängig vom Ergebnis E bzw. einer daraus abgeleiteten Spannung UA werden in dem stromüberwachten Leistungsschalter 28 (vgl. Figur 2) Schaltelemente angesteuert. Das Ergebnis E kann aber auch in einer nicht dargestellten Meßstation angezeigt werden.

Figur 2 zeigt ein Blockschaltbild des stromüberwachten Leistungsschalters 28. Solche stromüberwachten Leistungsschalter 28 werden z.B. zum Schalten einer Vielzahl von Motoren oder Lampen eingesetzt, wobei deren Stromaufnahme ständig überwacht wird, so daß ein Fehlerfall sofort erkannt wird und zum Ausschalten des Schalters führt. Insbesondere werden sie dann eingesetzt, wenn an den Betrieb der Motoren oder Lampen hohe Sicherheitsanforderungen gestellt werden, wie es z.B. in Flugzeugen der Fall ist.

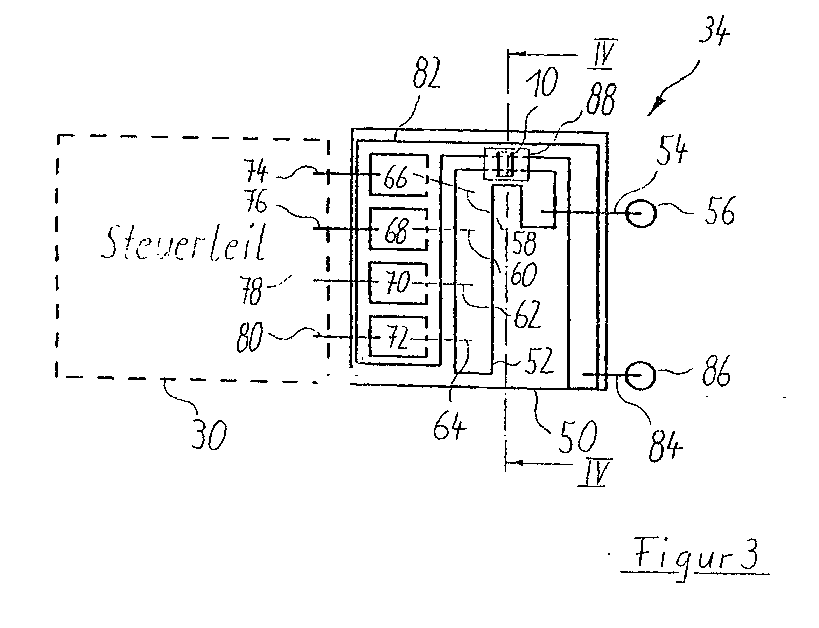

Ein Steuerteil 30 steuert über einen Optokoppler 32 ein anhand der Figur 3 näher erläutertes Leistungsteil 34 an. Abhängig von Steuerimpulsen, die über den Optokoppler 32 vom Steuerteil 30 zum Leistungsteil 34 übertragen werden, werden Schaltelemente im Leistungsteil 34 geschaltet. Ein Gleichstrom-Gleichstrom-Wandler 36 erzeugt aus einer Betriebsspannung (P, GND) eine Gleichspannung, mit der das Leistungsteil 34 arbeitet. Der Strom I, der durch die Last fließt, wird mit Hilfe des Stromsensors 8 erfaßt, der nach dem anhand der Figur 1 beschriebenen Wirkprinzip arbeitet, und die Spannung UA dem Steuerteil 30 zugeführt. Das Steuerteil 30 reagiert bei Abweichungen der Spannung UA von einem vorgegebenen Sollwert, die durch Änderungen des Stromes I bedingt sind, z.B. mit einem Öffnen der Schaltelemente im Leistungsteil 34.

Eine Anpassungsschaltung 40 zum Abgreifen der Spannung an der Last steuert einen Optokopler 42, der ein Statussignal erzeugt, das Auskunft über die Spannung an der Last gibt. Um die Schaltelemente des Leistungsteils 30 einzuschalten bzw. auszuschalten, wird an einen Eingang des Steuerteils 30 ein Kontrollsignal "EIN/AUS" z.B. auf den Wert "1" bzw. "0" gesetzt. Ein Signal "T" wird an einem Ausgang des Steuerteils 30 abgegriffen und dient der Rückmeldung des Betriebszustandes des Steuerteils 30. Es hat z.B. bei fehlerfreiem Betrieb einen Wert "0" und bei einem selbsttätigen Abschalten des sensitiven Schalters 28 im Fehlerfalle den Wert "1".

Figur 3 zeigt schematisch einen Aufbau des Leistungsteils 34 in Hybridtechnik. Auf einem Keramiksubstrat 50 befindet sich eine erste Leiterbahn 52, die über einen Bonddraht 54 mit einem Anschlußstift 56 verbunden ist. Die erste Leiterbahn 52 steht über Verbindungsdrähte 58 bis 64 mit den Drain-Anschlüssen von vier Feldeffekttransistoren 66 bis 72 in Verbindung. Die Feldeffekttransistoren 66 bis 72 werden über am jeweiligen Gate angeschlossene Verbindungsleitungen 74 bis 80 vom Emitter des Optokopplers 32 angesteuert und bilden die Schaltelemente des Leistungsteils 34. Die Source-Anschlüsse der Feldeffekttransistoren 66 bis 72 stehen mit einer zweiten Leiterbahn 82 in Verbindung. Von der zweiten Leiterbahn 82 führt ein Bonddraht 84 zu einem Anschlußstift 86.

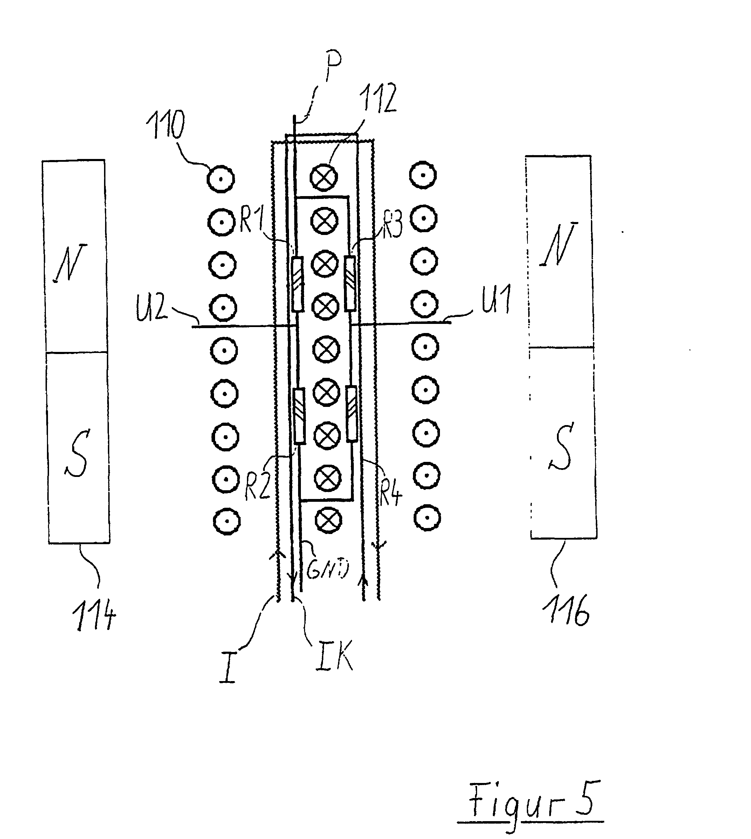

Der Magnetfeldsensor 10 ist, wie in der Figur 3 zu erkennen, unmittelbar über den Leiterbahnen 52 und 82 angeordnet. Die magnetfeldempfindlichen Widerstände sind auf dem Magnetfeldsensor 10 in der in Figur 5 gezeigten Art und Weise bezüglich des Stromes I angeordnet, der die Leiterbahnen 82 und 84 in entgegengesetzten Richtungen durchfließt. Eine Isolierplatte 88 aus Keramik verhindert Spannungsüberschläge zwischen den Leiterbahnen 52 und 82 sowie dem Magnetfeldsensor 10 und dient gleichzeitig als Abstandhalter. Durch die Dicke der Isolierplatte 88 wird außerdem der Abstand des Magnetfeldsensors 10 zu dem durch den Strom I hervorgerufenen Primärmagnetfeld eingestellt. Damit wird die Empfindlichkeit des Magnetfeldsensors 10 festgelegt.

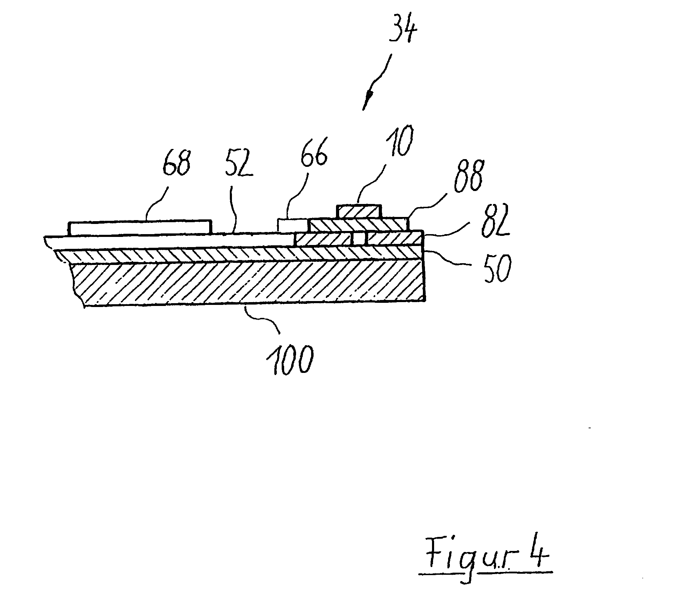

Figur 4 zeigt eine Schnittdarstellung des Leistungsteils in Hybridtechnik entlang des Schnittes IV nach Figur 3. Das Keramiksubstrat 50 steht mit einem Gehäuseboden 100 in Berührung. Der Gehäuseboden 100 hat eine gute Wärmeleitfähigkeit und schirmt den Magnetfeldsensor 10 gegenüber äußeren Magnetfeldern ab. Die Isolierplatte 88 hat wie bereits erwähnt eine hohe Isolierfestigkeit, um Spannungsüberschläge von den Leiterbahnen 52 und 82 zum Magnetfeldsensor 10 zu verhindern.

Figur 5 zeigt die Wirkungsweise des Magnetfeldsensors 10. Vier magnetoresistive Widerstände R1 bis R4 sind zu einer Brücke zusammengeschaltet, die mit einer Speisespannung (P, GND) gespeist ist. Auf den magnetoresistiven Widerständen R1 bis R4 ist jeweils durch eine Schraffur kenntlich gemacht, in welche Richtung sich der Widerstandswert bei einem zu erfassenden Strom I in der in Figur 5 gezeigten Richtung ändert. Gleiche Schraffurrichtungen bedeuten Widerstandsänderungen in die gleiche Richtung. Demzufolge ändern sich die magnetoresistiven Widerstände R1 und R4 in eine Richtung und die magnetoresistiven Widerstände R2 und R3 in die andere Richtung. In Figur 5 ist ein durch den Strom I hervorgerufenes Primärmagnetfeld 110, 112 eingezeichnet. Ein Kreis mit einem zentralen Punkt (z.B. 110) kennzeichnet senkrecht aus der Zeichenebene heraustretende Feldlinien und ein Kreis mit einem Kreuz (z.B. 112) kennzeichnet senkrecht in die Zeichenebene eintretende Feldlinien. Das Primärmagnetfeld 110, 112 wirkt mit seiner in der Zeichenebene liegenden horizontalen Komponente auf die magnetoresistiven Widerstände R1 bis R4 ein. Die magnetoresistiven Widerstände R1 und R4 ändern ihren Widerstand mit entgegengesetzten Vorzeichen wie die magnetoresistiven Widerstände R2 und R3. Dadurch wird die Brückenschaltung aus den magnetoresistiven Widerständen R1 bis R4 durch das mit dem Strom I verbundene Primärmagnetfeld 110, 112 maximal verstimmt.

Daß sich einer der magnetoresistiven Widerstände R1 bis R4 bei einem vorgegebenen Strom I und dem daraus resultierenden Primärmagnetfeld 110, 112 in eine bestimmte Richtung ändert, wird durch die innere Struktur der magnetoresistiven Widerstände R1 bis R4 bestimmt. Alternativ können bei magnetoresistiven Widerständen R1 bis R4 mit gleicher Struktur unterschiedliche Richtungen der Widerstandsänderung durch Veränderung der Anordnung der magnetoresistiven Widerstände R1 bis R4 erreicht werden. Zum Beispiel könnte der Strom I bei einem Verlauf wie in Figur 5 erst an den magnetoresistiven Widerständen R4 und R1 und anschließend an den Widerständen R3 und R2 vorbeifließen. Dazu müssen die magnetoresistiven Widerstände R2 und R4 vertauscht werden, wobei es zu einem Überkreuzen ihrer Anschlußleitungen zu den Spannungen U1 und U2 kommt. Die Richtung der Änderung des Widerstandes ist bei den magnetoresistiven Widerständen R1 bis R4 mit gleicher Struktur nur noch von der Richtung einer in der Zeichenebene liegenden horizontalen Magnetfeldkomponente abhängig.

Durch Verwenden von Dauermagneten 114 und 116 wird eine vertikale Magnetfeldkomponente in Längsrichtung der magnetoresistiven Widerstände R1 bis R4 erzeugt, die im folgenden Vorspannmagnetfeld Hx genannt wird. Das Vorspannmagnetfeld Hx hat einen zu vernachlässigenden Einfluß auf den Widerstand der magnetoresistiven Widerstände R1 bis R4, führt aber zum Vermeiden von Hystereseeffekten in den magnetoresistiven Widerständen R1 bis R4. Die Feldlinien der Dauermagneten 114 und 116 wurden aus Übersichtlichkeitsgründen in Figur 5 nicht dargestellt. Die magnetoresistiven Widerstände R1 bis R4 tragen zur Erhöhung ihrer Empfindlichkeit die oben genannten Barberpole.

Der Kompensationsstrom Ik fließt in einem im Vergleich zum Strom I kleineren Abstand an den magnetoresistiven Widerständen R1 bis R4 entlang. Er ist so gerichtet, daß das durch ihn hervorgerufene Kompensationsmagnetfeld (nicht dargestellt) dem Einfluß des Primärmagnetfeldes 110, 112 an den magnetoresistiven Widerständen R1 bis R4 entgegenwirkt, so daß auch der Verstimmung der Brücke entgegengewirkt wird.

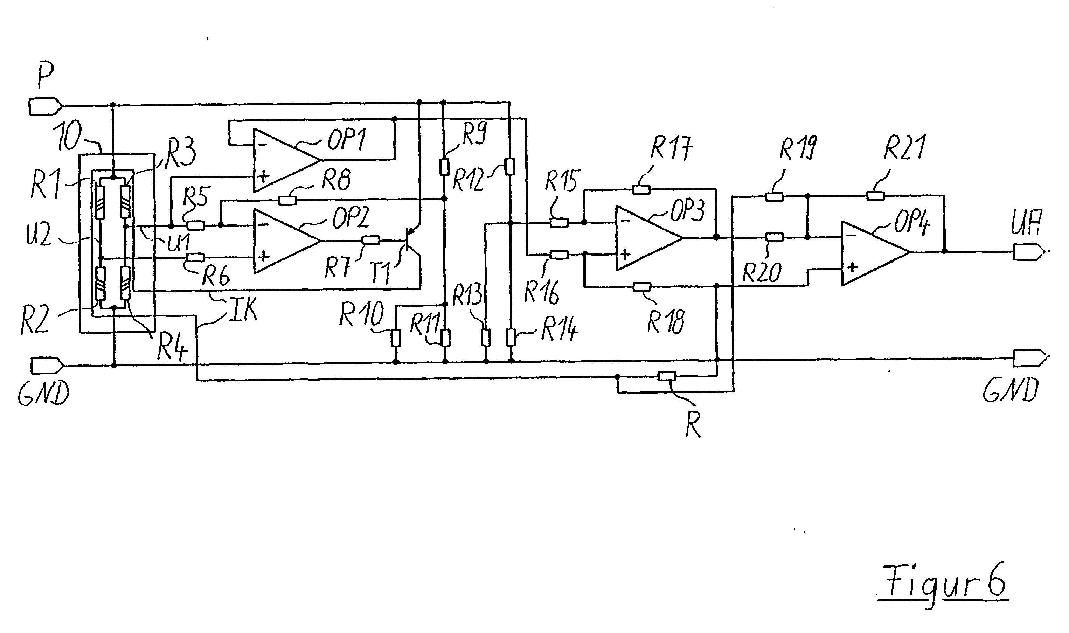

Figur 6 zeigt eine Schaltungsanordnung des Stromsensors 8 für einen unipolaren Strom I (nicht dargestellt). An die Schaltungsanordnung wird eine Speisespannung (P, GND) angelegt. Ein Operationsverstärker Op1 ist als Impedanzwandler geschaltet, der die Spannung am Widerstand R4, die mit der Spannung U1 identisch ist, einer weiter unten erläuterten Subtrahierschaltung zuführt.

Ein zweiter Operationsverstärker Op2 dient zum Erzeugen des Kompensationsstromes Ik. Die Spannung U1 der Brückenschaltung wird über einen Widerstand R5 an den invertierenden Eingang des Operationsverstärkers Op2 gelegt und die Spannung U2 wird über einen Widerstand R6 an den nicht invertierenden Eingang des Operationsverstärkers Op2 gelegt. Über einen Basiswiderstand R7 und einen Treibertransistor T1 wird der Kompensationsstrom Ik erzeugt, der wie erläutert einer Verstimmung der Brückenschaltung aus den magnetoresistiven Widerständen R1 bis R4 entgegenwirkt. Die Verstimmung der Brückenschaltung wird durch den in Figur 6 nicht dargestellten Strom I und/ oder durch eine Verstimmung der Brücke infolge von Schwankungen der Umgebungstemperatur hervorgerufen.

Zur Kompensation eines Spannungsoffsets der Brückenschaltung wird eine Offsetkompensation mit Hilfe von Widerständen R8 bis R11 bei der Bezugstemperatur T25 von 25°C durchgeführt. Die Widerstände R8 bis R11 sind so bemessen, daß der Kompensationsstrom Ik bei der Bezugstemperatur von 25°C und bei einem Strom I von I=0 A zu Null wird.

Durch weitere Widerstände R12 bis R14 wird die Bezugsspannung UT25 bei 25°C am invertierenden Eingang eines dritten Operationsverstärkers Op3 eingestellt, so daß sich am Sensorausgang bei der Bezugstemperatur T25 eine Spannung UA von UA=0 V ergibt. Der Operationsverstärker Op3 ist als Subtrahierschaltung mit Widerständen R15 bis R18 beschaltet. Er bildet eine Differenz aus der über den Operationsverstärker Op1 abgegriffenen Spannung U1 und der Bezugsspannung UT25. Das Ergebnis am Ausgang des Operationsverstärkers Op3 wird einem vierten Operationsverstärker Op4 zugeführt. Der Operationsverstärker Op4 ist mit Hilfe von Widerständen R19 bis R21 als Addierschaltung geschaltet. An seinem Ausgang liegt die Ausgangsspannung UA an. Die Addierschaltung multipliziert gleichzeitig die Ausgangsspannung des Operationsverstärkers Op3 mit einem Einmeßfaktor K, so daß eine Korrekturgröße entsteht, die zu einer Spannung addiert wird, die an einem vom Kompensationsstrom Ik durchflossenen niederohmigen Präzisionswiderstand R abgegriffen wird. Durch Vertauschen der Eingänge des Operationsverstärkers Op3 kann das Vorzeichen des Einmeßfaktors K umgedreht werden. Der jeweilige konkrete Wert des Einmeßfaktors K wird abhängig vom tatsächlichen Magnetfeldsensor 10 in dem noch beschriebenen Einmeßvorgang bestimmt.

Die Ausgangsspannung UA wird wie erwähnt dem Steuerteil 30 des stromüberwachten Leistungsschalters 28 zugeführt. Sie kann auch einer nicht dargestellten Meßstation zugeführt werden.

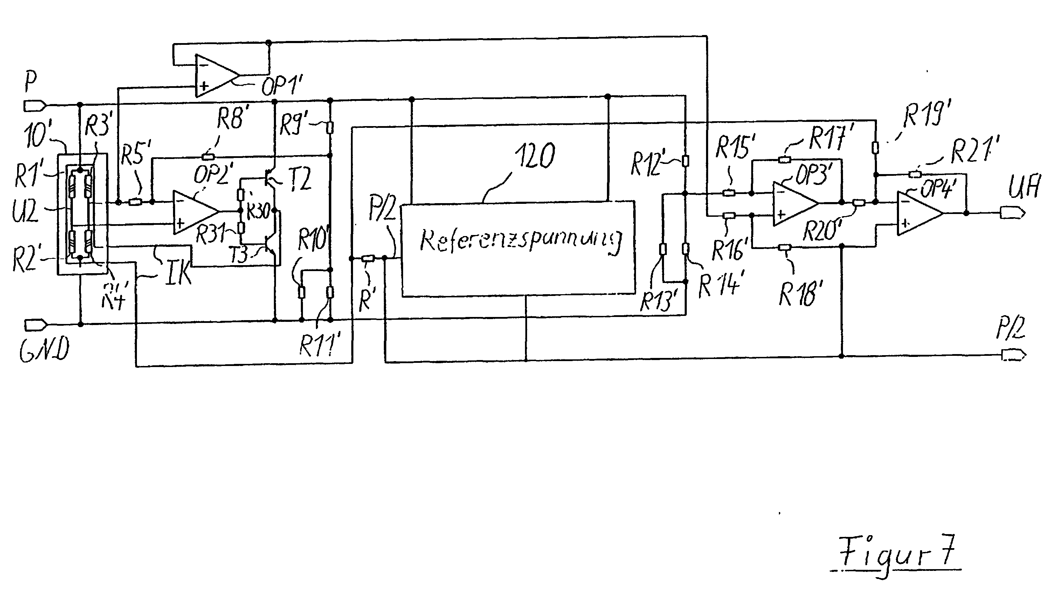

Figur 7 zeigt eine Schaltung des Stromsensors 8 für bipolare Ströme I. Bauelemente mit gleicher Wirkung erhalten das gleiche Bezugzeichen wie in Figur 6, jedoch mit einem Strich, und werden nicht noch einmal erläutert.

Anstelle des Treibertransistors T1 werden in Figur 7 zwei Treibertransistoren T2 und T3 verwendet, die so geschaltet sind, daß der Kompensationsstrom Ik je nach Richtung des Stromes I (nicht dargestellt) positiv oder negativ ist. Am Meßwiderstand R wird eine Referenzspannung von P/2 angelegt. Die Referenzspannung von P/2 wird mit Hilfe einer bekannten Schaltungsanordnung 120 zum Erzeugen einer Referenzspannung erzeugt. Das Sensorausgangssignal UA nimmt je nach Richtung des Stromes I und damit des Kompensationsstromes Ik unterschiedliche Vorzeichen an.

Die in den Figuren 6 und 7 angegebenen Schaltungen können mit Operationsverstärkern Op1 bis Op4 bzw. Op1' bis Op4' mit bipolarer oder unipolarer Spannungsversorgung realisiert werden.

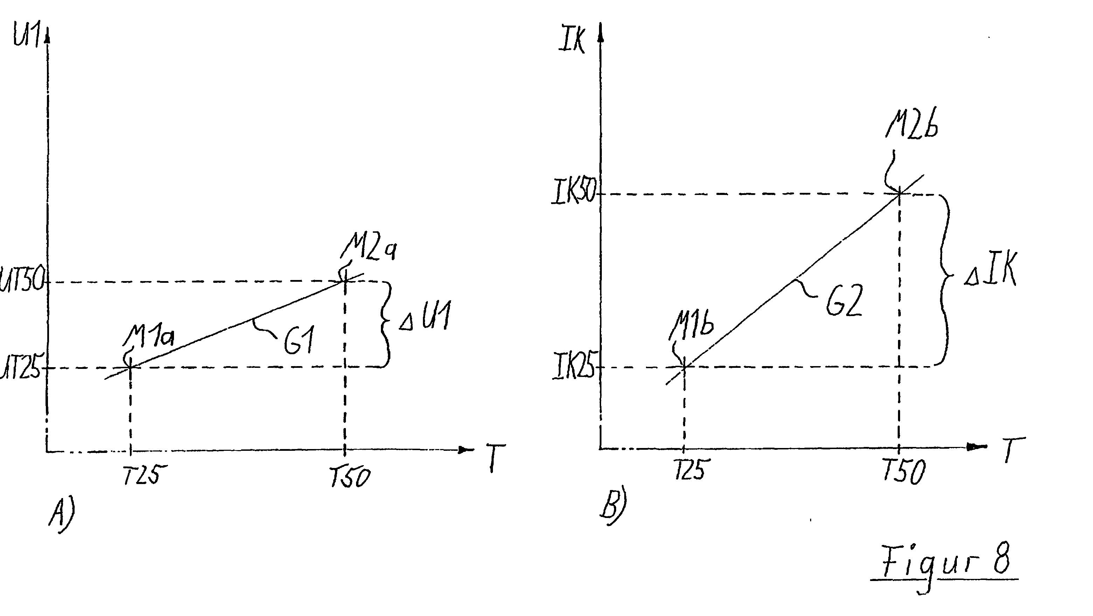

Figur 8 zeigt zwei Diagramme A und B mit deren Hilfe der Einmeßvorgang zum Bestimmen des Einmeßfaktors K erläutert wird. Im Diagramm A ist in einem Koordinatensystem ein durch zwei Meßwerte M1a und M2a linear approximierter Verlauf der Spannung U1 abhängig von der Temperatur T dargestellt. Auf der Abszissenachse ist die Temperatur T und auf der Ordinatenachse ist die Spannung U1 abgetragen. Im Diagramm B ist in einem Koordinatensystem ein durch zwei Meßpunkte M1b und M2b linear approximierter Verlauf des auf der Ordinatenachse abgetragenen Kompensationsstromes Ik abhängig von der auf der Abszissenachse abgetragenen Temperatur T abgetragen.

Die Achsen der Koordinatensysteme in den Diagrammen A, B sind in der Nähe des jeweiligen Koordinatenursprungs unterbrochen, um kenntlich zu machen, daß in der Figur 8 zur deutlichen Darstellung nur quantitative Zusammenhänge dargestellt sind.

Beim Einmeßvorgang wird eine erste Meßung M1 bei der Bezugstemperatur T25 von 25°C durchgeführt. Bei einem vorgegebenen Strom I wird die Spannung U1 als ein Spannungswert UT25 erfaßt und im Diagramm A als Meßwert M1a eingetragen. Bei unverändertem Strom I wird auch der Kompensationsstrom Ik als Stromwert Ik25 bei der Bezugstemperatur T25 erfaßt und im Diagramm B als Meßwert M1b eingetragen.

Bestandteil des Einmeßvorganges ist weiterhin eine zweite Messung, bei der der Magnetfeldsensor 10 eine Temperatur T50 von 50°C hat. Bei demselben Strom I wie auch in der ersten Messung wird die Spannung U1 als ein Spannungswert UT50 erfaßt und im Diagramm A als Meßwert M2a eingetragen. Bei unverändertem Strom wird auch der Kompensationsstrom Ik als Stromwert Ik50 erfaßt und in Diagramm B eingetragen.

Wie oben erläutert, läßt sich bei geeigneter Wahl der magnetoresistiven Widerstände R1 bis R4 ein lineares Verhalten sowohl der Spannung U1 als auch des Kompensationsstromes Ik abhängig von der Temperatur T erreichen. Aus diesem Grunde brauchen im Einmeßvorgang nur zwei Messungen jeweils für die Spannung U1 und den Kompensationsstrom Ik durchgeführt werden.

Durch die Meßwerte M1a und M2a kann somit eine Gerade G1 gelegt werden. Durch die Meßwerte M1b und M2b wird eine Gerade G2 gelegt. Die Erfindung beruht wie oben erläutert darauf, den Einfluß der Temperatur T auf den Kompensationsstrom Ik mit Hilfe der Spannung U1 zu erfassen. Die beim Einmeßvorgang durchgeführte Temperaturänderung von 25°C auf 50°C hat ein Erhöhen der Spannung U1 und ein Erhöhen des Kompensationsstromes Ik zur Folge. Die Spannung U1 erhöht sich um ΔU1, wobei ΔU1 die Differenz aus UT50 und UT25 ist. Der Kompensationsstrom Ik erhöht sich um ΔIk, wobei ΔIk die Differenz aus Ik50 und Ik25 ist. Je nach Größe des Meßwiderstandes R gehört zu ΔIk eine Spannungserhöhung ΔM. Es ist natürlich auch möglich, die Spannungserhöhung ΔM am Meßwiderstand R direkt zu messen.

Eine Kompensation des Einflusses der Temperatur T auf den Kompensationsstrom Ik würde erreicht werden, wenn zum Kompensationsstrom bzw. zu einer aus ihm abgeleiteten Meßgröße ein Wert derart addiert wird, daß die Gerade G2 einen Anstieg von Null hat. Unabhängig von der Temperatur T wird in diesem Fall eine zum Strom I gehörende Meßgröße erfaßt. Das gilt insbesondere auch für eine Temperatur von 25°C und 50°C.

Soll die Stromänderung ΔIk bzw. die damit verbundene Spannungsänderung ΔM kompensiert werden, so muß eine Kompensationsspannung für die Spannungserhöhung ΔM genau den gleichen Betrag wie die Spannungserhöhung ΔM haben, jedoch ein anderes Vorzeichen besitzen. Es muß demzufolge eine der beiden folgenden Formeln gelten:

$$\Delta Ik \cdot R + K \cdot \Delta U1 = 0 \qquad (1) \text{ bzw.}$$

$$\Delta M + K \cdot \Delta U1 = 0 \qquad (2)$$

Mit Formel (1) oder Formel (2) läßt sich der Einmeßfaktor K ermitteln:

$$K = \frac{-\Delta Ik \cdot R}{\Delta U1} \qquad (3) \text{ bzw.}$$

$$K = \frac{-\Delta M}{\Delta U1} \qquad (4)$$

Aufgrund der beschriebenen linearen Zusammenhänge zwischen Temperatur T und Spannung U1 auf der einen Seite sowie zwischen Temperatur T und Kompensationsstrom Ik auf der anderen Seiten wird mit einem nach der Formel (3) oder (4) ermittelten Einmeßfaktor K bei jeder Temperatur T der Einfluß der Temperatur T auf das Meßergebnis kompensiert.

**Patentansprüche**

1. Verfahren zum potentialfreien Erfassen eines Stromes (I), insbesondere eines Ausgangsstromes in einem stromüberwachten Leistungsschalter (28),
   bei dem ein Magnetfeldsensor (10) vier zu einer mit einer Speisespannung gespeisten Brückenschaltung zusammengeschaltete Bauelemente enthält, wovon mindestens zwei Bauelemente magnetfeldempfindlich sind, die einem durch den Strom (I) hervorgerufenen Primärmagnetfeld (110, 112) ausgesetzt werden,
   bei dem die Brückenspannung (UD) der Brückenschaltung einer Regeleinheit (12; Op2, T1; Op2', T2, T3) zugeführt wird, welche einen Kompensationsstrom (Ik) erzeugt, dessen Kompensationsmagnetfeld derart auf die magnetfeldempfindlichen Bauelemente einwirkt, daß die Brückenspannung (UD) einen betragsmäßig minimalen Wert annimmt,
   und bei dem aus dem Kompensationsstrom (Ik) ein Meßsignal (M) ermittelt wird, welches als Maß für den Strom (I) dient,
   **dadurch gekennzeichnet, daß** die Spannung (U1) an mindestens einem der Bauelemente erfaßt und mit einer Bezugsspannung (UT25) an diesem Bauelement für eine vorgegebene Temperatur (T25) verglichen wird, und daß das Meßsignal (M) abhängig vom Vergleichsergebnis korrigiert wird.

2. Verfahren nach Anspruch 1, **dadurch gekennzeichnet, daß** sämtliche Bauelemente der Brückenschaltung als magnetoresistive Widerstände (R1 bis R4) ausgebildet sind.

3. Verfahren nach Anspruch 1, **dadurch gekennzeichnet, daß** jedes magnetfeldempfindliche Bauelement der Brückenschaltung als magnetoresistiver Widerstand ausgebildet ist, und daß die verbleibenden Bauelemente der Brückenschaltung Festwiderstände sind.

**4.** Verfahren nach Anspruch 2 oder 3, **dadurch gekennzeichnet, daß** in jedem magnetoresistiven Widerstand die Magnetachse der bevorzugten Magnetisierung um einen zwischen 0 DEG und 90 DEG liegenden Winkel, vorzugsweise um etwa 45 DEG gegen die Richtung des Stromflußes geneigt ist.

**5.** Verfahren nach Anspruch 2, 3 oder 4, **dadurch gekennzeichnet, daß** die magnetoresistiven Widerstände in ihrer Längsrichtung von einem vorzugsweise durch mindestens einen Dauermagneten (114, 116) erzeugten Vorspannmagnetfeld (Hx) durchsetzt werden.

**6.** Verfahren nach Anspruch 2, 3 oder 4, **dadurch gekennzeichnet, daß** die Führung des Stromes (I) und des durch ihn erzeugten Primärmagnetfeldes (110, 112) und/oder die Ausrichtung der Magnetachsen der magnetoresistiven Widerstände derart ist, daß in einander benachbarten magnetoresistiven Widerständen abwechselnd positive und negative Widerstandsänderungen bei Änderung des auf sie einwirkenden Primärmagnetfeldes bzw. des Kompensationsmagnetfeldes auftreten.

**7.** Verfahren nach einem der vorhergehenden Ansprüche, **dadurch gekennzeichnet, daß** zum Vergleich eine Differenz (D) der Spannung (U1) aus dem mindestens einer der Bauelemente und der Bezugsspannung (UT25) gebildet wird.

**8.** Verfahren nach Anspruch 7, **dadurch gekennzeichnet, daß** die mit einem Einmeßfaktor (K) multiplizierte Differenz (D) zum Meßsignal (M) addiert wird, und daß das Ergebnis (E, UA) als Maß für den Strom (I) verwendet wird.

**9.** Verfahren nach Anspruch 8, **dadurch gekennzeichnet, daß** das Bilden der Differenz (D), das Multiplizieren des Einmeßfaktors (K) und das anschließende Addieren in einer digitalen Steuerung erfolgen.

**10.** Verfahren nach einem der Ansprüche 8 oder 9, **dadurch gekennzeichnet, daß** der Einmeßfaktor (K) durch einen Einmeßvorgang ermittelt wird wobei der Strom (3) unverändert bleibt.

**11.** Verfahren nach Anspruch 10, **dadurch gekennzeichnet, daß** beim Einmeßvorgang der Einmeßfaktor (K) mit Hilfe mindestens zweien Messungen der Spannung (M1a, M2a) an dem mindestens einen des Bauelemente und des Kompensationsstromes (M1b, M2b) bei unterschiedlicher Temperatur bestimmt wird.

**12.** Verfahren nach einem der vorhergehenden Ansprüche, **dadurch gekennzeichnet, daß** der Kompensationsstrom (Ik) einen Widerstand (R, R') durchfließt, an dem das Meßsignal (M) abgegriffen wird.

**13.** Verfahren nach einem der vorhergehenden Ansprüche, **dadurch gekennzeichnet, daß** die Regeleinheit (12; Op2, T1; Op2', T2, T3) eine Offsetkompensation (R8 bis R11, R8' bis R11') enthält, so daß bei einem Strom (I) von Null auch der Kompensationsstrom (Ik) bei der vorgegebenen Temperatur (T25) den Wert Null hat.

**14.** Verfahren nach einem der vorhergehenden Ansprüche, **dadurch gekennzeichnet, daß** der Kompensationsstrom (Ik) in einem geringeren Abstand als der Strom (I) an den magnetfeldempfindlichen Bauelementen (R1 bis R4) vorbeigeführt wird.

**15.** Verfahren nach einem der vorhergehenden Ansprüche, **dadurch gekennzeichnet, daß** die magnetfeldempfindlichen Bauelemente (R1 bis R4) in Dünnschichttechnik ausgeführt sind.

**16.** Verfahren nach einem der vorhergehenden Ansprüche, **dadurch gekennzeichnet, daß** die elektronischen Komponenten auf einem Hybridschaltkreis angeordnet sind.

**17.** Vorrichtung zum Durchführen des Verfahrens nach einem der Ansprüche 1 bis 16, mit einem Magnetfeldsensor (10), der vier zu einer mit einer Speisespannung gespeisten Brückenschaltung zusammengeschaltete Bauelemente enthält, wovon mindestens zwei Bauelemente magnetfeldempfindlich sind, die einem durch den Strom (I) hervorgerufenen Primärmagnetfeld (110, 112) ausgesetzt werden,

    einer Regeleinheit (12; Op2, T1; Op2', T2, T3), welche abhängig von der Brückenspannung (UD) der Brückenschaltung einen Kompensationsstrom (Ik) erzeugt, dessen Kompensationsmagnetfeld derart auf die magnetfeldempfindlichen Bauelemente einwirkt, daß die Brückenspannung (UD) einen betragsmäßig minimalen Wert annimmt,

    und mit einer Wandlereinheit (R;R'), die aus dem Kompensationsstrom (Ik) ein Meßsignal (M) ermittelt, welches als Maß für den Strom (I) dient,

    **dadurch gekennzeichnet, daß** die Vorrichtung

    eine Einrichtung zur Erfassung der Spannung (U1) an mindestens einem der Bauelemente der Brückenschaltung,

    eine Vergleichsschaltung (Op3, Op3') zum Vergleich der Spannung (U1) mit einer Bezugsspannung (UT25) an diesem Bauelement der Brückenschaltung für eine vorgegebene Temperatur (T25) und

eine Korrekturschaltung (Op4; Op4') zur Korrektur des Meßsignals (M) abhängig vom Vergleichsergebnis

enthält.

18. Stromüberwachter Leistungsschalter (28), **dadurch gekennzeichnet, daß** er eine Vorrichtung nach Anspruch 17 zur potentialfreien Messung des Ausgangsstromes (I) enthält.

19. Stromüberwachter Leistungsschalter (28) nach Anspruch 18, **dadurch gekennzeichnet, daß** er

ein Leistungsteil (34) mit mindestens einem Schaltelement (66 bis 72) zum Schalten des Stromes (I) und

ein Steuerteil (30) zum berührungslosen Ansteuern des Schaltelements bzw. der Schaltelemente (66 bis 72) durch einen Optokoppler (32) enthält,

wobei das Steuerteil (30) ein aus dem korrigierten Meßsignal (M) gebildetes Signal (E, UA) mit einem vorgegebenen Sollwert vergleicht und beim Überschreiten des Sollwertes das Schaltelement bzw. die Schaltelemente stromlos schaltet.

**Claims**

1. A process for the potential-free detection of a current (I), in particular of an output current in a current-monitored circuit breaker (28),

wherein a magnetic field sensor (10) includes four components coupled into one bridge circuit supplied with a supply voltage, of which at least two components which are exposed to a primary magnetic field (110,112) generated by the current (I) are magnetic field sensitive,

wherein the bridge voltage (UD) of the bridge circuit is fed to a regulator unit (12; Op2, T1; Op2', T2, T3), which generates a compensation current (Ik), whose compensation magnetic field acts on the magnetic-field-sensitive components such that the bridge voltage (UD) assumes a quantitatively minimal value,

and wherein a measuring signal (M) is determined from the compensation current (Ik), which measuring signal serves as a measure of the current (I),

**characterised in that** the voltage (U1) is detected on at least one of the components and is compared with a reference voltage (UT25) on that component for a predefined temperature (T25), and that the measuring signal (M) is corrected as a function of the result of the comparison.

2. The process according to Claim 1, **characterised in that** all components of the bridge circuit are designed as magnetoresistive resistors (R1 through R4).

3. The process according to Claim 1, **characterised in that** each magnetic-field-sensitive component of the bridge circuit is designed as a magnetoresistive resistor and that the remaining components of the bridge circuit are fixed resistors.

4. The process according to Claim 2 or Claim 3, **characterised in that** in each magnetoresistive resistor the magnetic axis of the preferred magnetization is aligned at an angle between 0° and 90°, preferably by approximately 45° relative to the direction of the flow of the current.

5. The process according to Claim 2, 3 or 4, **characterised in that** the magnetoresistive resistors are in their lengthwise direction passed through by a biasing magnetic field (Hx), preferably generated by at least one permanent magnet (114,116).

6. The process according to Claim 2, 3 or 4, **characterised in that** the path of the current (I) and the primary magnetic field (110,112) generated by it and/or the alignment of the magnetic axes of the magnetoresistive resistors is such that in magnetoresistive resistors adjacent to each other, alternatingly positive and negative resistance changes occur with a change of the primary magnetic field or of the compensation magnetic field acting on them.

7. The process according to one of the preceding claims, **characterised in that** a difference (D) of the voltage (U1) on at least one of the components and the reference voltage (UT25) is calculated for the comparison.

8. The process according to Claim 7, **characterised in that** the difference (D) multiplied by a calibration factor (K) is added to the measuring signal (M) and that the result (E,UA) is used as a measure for the current (I) .

9. The process according to Claim 8, **characterised in that** the calculation of the difference (D), the multiplication of the calibration factor (K), and the subsequent addition take place in a digital controller.

10. The process according to one of Claims 8 or 9, **characterised in that** the calibration factor (K) is determined by a calibration procedure in which the current (I) remains unchanged.

11. The process according to Claim 10, **characterised in that** the calibration procedure the calibration factor (K) is determined using at least two measurements of the voltage (M1a, M2a) on at least one of the components and of the compensation current (Mlb, M2b) at different temperatures.

12. The process according to one of the preceding claims, **characterised in that** the compensation current (Ik) flows through a resistor (R,R') from which the measuring signal (M) is tapped.

13. The process according to one of the preceding claims, **characterised in that** the regulator unit (12; Op2, T1; Op2', T2, T3) includes an offset compensation (R8 through R11, R8' through R11') such that with a current (I) of zero, the compensation current (Ik) also has the value zero at the predefined temperature (T25).

14. The process according to one of the preceding claims, **characterised in that** the compensation current (Ik) is passed by the magnetic-field-sensitive components (R1 through R4) at a distance less than the current (I).

15. The process according to one of the preceding claims, **characterised in that** the magnetic-field-sensitive components (R1 through R4) are implemented in thin-film technology.

16. The process according to one of the preceding claims, **characterised in that** the electronic components are disposed on a hybrid circuit.

17. An arrangement for performance of the process according to one of Claims 1 through 16, with a magnetic field sensor (10), which includes four components coupled into one bridge circuit supplied with a supply voltage, of which at least two components which are exposed to a primary magnetic field (110,112) generated by the current (I) are magnetic field sensitive,
a regulator unit (12; Op2, T1; Op2', T2, T3), which generates a compensation current (Ik) as a function of the bridge voltage (UD) of the bridge circuit, whose compensation magnetic field acts on the magnetic-field-sensitive components such that the bridge voltage (UD) assumes a quantitatively minimal value,
and with a converter unit (R;R'), which determines a measuring signal (M) from the compensation current (Ik), which signal serves as a measure for the current (I),
**characterised in that** the arrangement comprises:

means for detecting the voltage (U1) on at least one of the components of the bridge circuit;
a comparison circuit (Op3; Op3') for comparing the voltage (U1) with a reference voltage (UT25) on that component of the bridge circuit for a predefined temperature (T25); and

a correction circuit (Op4; Op4') for correcting the measuring signal (M) as a function of the comparison result.

18. A current-monitored circuit breaker (28) **characterised in that** it comprises an arrangement according to Claim 17 for potential-free measurement of the output current (I).

19. A current-monitored circuit breaker (28) according to Claim 18, **characterised in that** it includes
a power module (34) with at least one switch element (66 through 72) to switch the current (I) and
a control section (30) for contact-free driving of the switch element(s) (66 through 72) via an optocoupler (32) ,
whereby the control section (30) compares a signal (E,UA) calculated from the corrected measuring signal (M) with a predefined desired value and cuts off the current supply to the switch element(s) if the desired value is exceeded.

**Revendications**

1. Procédé destiné à la détection à potentiel flottant d'un courant (I), en particulier d'un courant de sortie dans un sectionneur de puissance (28) à surveillance de courant,
avec lequel un capteur de champ magnétique (10) contient quatre composants montés pour former un circuit de pont alimenté par une tension d'alimentation, parmi lesquels au moins deux composants sont sensibles aux champs magnétiques et sont soumis à un champ magnétique primaire ( 110, 112) induit par le courant (I),
avec lequel la tension de pont (UD) du circuit en pont est branchée à une unité de régulation (12 ; Op2, T1 ; Op2', T2, T3) qui génère un courant de compensation (Ik) dont le champ magnétique de compensation agit de telle façon sur les composants sensibles aux champs magnétiques que la tension de pont (UD) prenne une valeur minimale en valeur absolue,
et avec lequel un signal de mesure (M) est déterminé à partir du courant de compensation (Ik), lequel signal sert de référence pour le courant (I),
**caractérisé en ce que** la tension (U1) est détectée au niveau d'au moins un des composants et comparée à une tension de référence (UT25) au niveau de ce composant pour une température prédéfinie (T25), et **en ce que** le signal de mesure (M) est corrigé en fonction du résultat de la comparaison.

2. Procédé selon la revendication 1, **caractérisé en ce que** tous les composants du circuit en pont sont constitués de résistances magnétorésistives (R1 à R4)).

3. Procédé selon la revendication 1, **caractérisé en ce que** chaque composant du circuit en pont sensible aux champs magnétiques est constitué par une résistance magnétorésistive et **en ce que** les composants restants du circuit en pont sont des résistances fixes.

4. Procédé selon la revendication 2 ou 3, **caractérisé en ce que**, dans chaque résistance magnétorésistive, l'axe magnétique de la magnétisation induite est incliné d'un angle compris entre 0 degré et 90 degrés, de préférence d'environ 45 degrés, par rapport à la direction du flux du courant.

5. Procédé selon la revendication 2, 3 ou 4 **caractérisé en ce que** les résistances magnétorésistives sont soumises dans leur direction axiale à un champ magnétique de prétension (Hx) généré de préférence par au moins un aimant permanent ( 114, 116).

6. Procédé selon la revendication 2, 3 ou 4, **caractérisé en ce que** la commande du courant (I) et du champ magnétique primaire (110, 112) généré par ce courant et/ou l'orientation de l'axe magnétique des résistances magnétorésistives est telle que dans des résistances magnétorésistives voisines l'une de l'autre des variations de résistance alternativement positives et négatives apparaissent en cas de modification du champ magnétique primaire respectivement du champ magnétique de compensation agissant sur elles.

7. Procédé selon l'une quelconque des revendications précédentes, **caractérisé en ce que**, à des fins de comparaison, est formée une différence (D) de la tension (U1) au niveau d'au moins un des composants et de la tension de référence (UT25).

8. Procédé selon la revendication 7, **caractérisé en ce que** la différence (D) multipliée par un facteur de mesure (K) est ajoutée au signal de mesure (M), et **en ce que** le résultat (E, UA) est employé comme référence pour le courant (I).

9. Procédé selon la revendication 8, **caractérisé en ce que** la formation de la différence (D), la multiplication du facteur de mesure (K) et l'addition consécutive ont lieu dans une commande numérique.

10. Procédé selon l'une quelconque des revendications 8 ou 9, **caractérisé en ce que** le facteur de mesure (K) est déterminé par une opération de mesure au cours de laquelle le courant (I) demeure inchangé.

11. Procédé selon la revendication 10, **caractérisé en ce que**, lors de l'opération de mesure, le facteur de mesure (K) est déterminé à l'aide d'au moins deux mesures de la tension (M1a, M2a), en au moins un des composants, et du courant de compensation (M1b, M2b) à des températures différentes.

12. Procédé selon l'une quelconque des revendications précédentes, **caractérisé en ce que** le courant de compensation (Ik) traverse une résistance (R, R') au niveau de laquelle le signal de mesure (M) est détecté.

13. Procédé selon l'une quelconque des revendications précédentes, **caractérisé en ce que** l'unité de régulation (12 ; Op2, T1 ; Op2', T2, T3) contient une compensation de décalage (offset) (R8 à R11, R8' à R11') de sorte que, avec un courant (I) nul, le courant de compensation (Ik) ait également une valeur nulle à une température prédéfinie (T25).

14. Procédé selon l'une quelconque des revendications précédentes, **caractérisé en ce que** le courant de compensation (Ik) passe à côté des composants (R1 à R4) sensibles aux champs magnétiques à une distance plus faible que celle pour le courant (I)

15. Procédé selon l'une quelconque des revendications précédentes, **caractérisé en ce que** les composants sensibles aux champs magnétiques (R1 à R4) sont fabriqués avec la technique à couche mince.

16. Procédé selon l'une quelconque des revendications précédentes, **caractérisé en ce que** les composants électroniques sont disposés sur un circuit hybride.

17. Dispositif pour mettre en oeuvre le procédé selon l'une quelconque des revendications 1 à 16,

avec un capteur de champ magnétique (10) qui contient quatre composants montés pour former un circuit de pont alimenté par une tension d'alimentation, parmi lesquels au moins deux composants sont sensibles aux champs magnétiques et sont soumis à un champ magnétique primaire ( 110, 112) induit par le courant (I),

avec une unité de régulation (12 ; Op2, T1 ; Op2', T2, T3) qui, en fonction de la tension de pont (UD) du circuit en pont, génère un courant de compensation (Ik) dont le champ magnétique de compensation agit de telle façon sur les composants sensibles aux champs magnétiques que la tension de pont (UD) prenne une valeur minimale en valeur absolue,

et avec une unité de conversion (R ; R') qui détermine un signal de mesure (M) à partir du courant de compensation (Ik), lequel signal sert de référence pour le courant (I),

**caractérisé en ce que** le dispositif contient

une installation pour détecter la tension (U1) au niveau d'au moins un des composants du circuit en pont

un circuit de comparaison (Op3, Op3') pour comparer la tension (U1) avec une tension de référence (UT25) au niveau de ce composant du circuit en pont pour une température prédéfinie (T25) et

un circuit de correction (Op4 ; Op4') pour corriger le signal de mesure (M) en fonction du résultat de la comparaison.

18. Sectionneur de puissance à surveillance du courant (28), **caractérisé en ce qu'**il contient un dispositif selon la revendication 17 pour la mesure à potentiel flottant du courant de sortie (I).

19. Sectionneur de puissance avec surveillance du courant (28) selon la revendication 18, **caractérisé en ce qu'**il contient

une partie de puissance (34) avec au moins un élément de commutation (66 à 72) pour brancher le courant (I) et

une partie de commande (30) pour piloter sans contact l'élément de commutation respectivement les éléments de commutation (66 à 72) par le biais d'un optocoupleur (32),

la partie de commande (30) comparant un signal (E, UA), formé à partir du signal de mesure (M) corrigé, à une valeur de consigne prédéfinie et coupant le courant de l'élément de commutation respectivement des éléments de commutation en cas de dépassement de la valeur de consigne.

Figur 1

Figur 2

Figur 3

EP 0 782 002 B1

EP 0 782 002 B1

34

68  52  66  10  88

82

50

100

Figur 4

Figur 5

Figur 6

Figur 7

Figur 8